## Europäisches Patentamt

(19) **European Patent Office**

**Office européen des brevets**

(11) Publication number: **0 153 618**
**B1**

(12) **EUROPEAN PATENT SPECIFICATION**

(45) Date of publication of patent specification: **13.06.90**

(51) Int. Cl.⁵: **H 01 L 21/48**, H 01 L 23/14

(21) Application number: **85101186.6**

(22) Date of filing: **05.02.85**

(54) **Method for preparing highly heat-conductive substrate and copper wiring sheet usable in the same.**

(30) Priority: **24.02.84 JP 32628/84**

(43) Date of publication of application:
**04.09.85 Bulletin 85/36**

(45) Publication of the grant of the patent:
**13.06.90 Bulletin 90/24**

(84) Designated Contracting States:
**DE FR GB**

(56) References cited:
**EP-A-0 135 603**
**DE-C-3 345 219**
**GB-A- 980 622**

**PATENTS ABSTRACTS OF JAPAN, vol. 6, no. 77 (E-106)955r, 14th May 1982; & JP-A-57 15 446 (HITACHI SEISAKUSHO K.K.) 26-01-1982**

**PATENTS ABSTRACTS OF JAPAN, vol. 9, no. 150 (E-324)1873r, 25th June 1985; & JP-A-60 32 343 (TOSHIBA K.K.) 19-02-1985**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Nakahashi, Masako**
**c/o Kabushiki Kaisha Toshiba 72, Horikawa-cho Saiwai-ku Kawasaki-shi Kanagawa-ken (JP)**
Inventor: **Shirokane, Makoto**
**c/o Kabushiki Kaisha Toshiba 72, Horikawa-cho Saiwai-ku Kawasaki-shi Kanagawa-ken (JP)**
Inventor: **Yamazaki, Tatsuo**
**c/o Kabushiki Kaisha Toshiba 72, Horikawa-cho Saiwai-ku Kawasaki-shi Kanagawa-ken (JP)**
Inventor: **Yoshino, Hisashi**
**c/o Kabushiki Kaisha Toshiba 72, Horikawa-cho Saiwai-ku Kawasaki-shi Kanagawa-ken (JP)**
Inventor: **Hori, Akio**
**c/o Kabushiki Kaisha Toshiba 72, Horikawa-cho Saiwai-ku Kawasaki-shi Kanagawa-ken (JP)**
Inventor: **Takeda, Hiromitsu**
**c/o Kabushiki Kaisha Toshiba 72, Horikawa-cho Saiwai-ku Kawasaki-shi Kanagawa-ken (JP)**

(74) Representative: **Hansen, Bernd, Dr.rer.nat. et al**
**Hoffmann, Eitle & Partner Patentanwälte**
**Arabellastrasse 4 Postfach 81 04 20**
**D-8000 München 81 (DE)**

Courier Press, Leamington Spa, England.

## Description

This invention relates to a method for bonding a Cu member to an AlN substrate and a copper wiring sheet (hereinafter "Cu wiring sheet") usable in the method.

Recently, for a power semiconductor element, various requirements such as high density integration, hybridization and further control of a large quantity of current are requested. When these requirements are satisfied, the large amount of heat generated from the semiconductor element raises a problem. Thus it is necessary to radiate the large quantity of heat generated to prevent elevation of temperature of the semiconductor element.

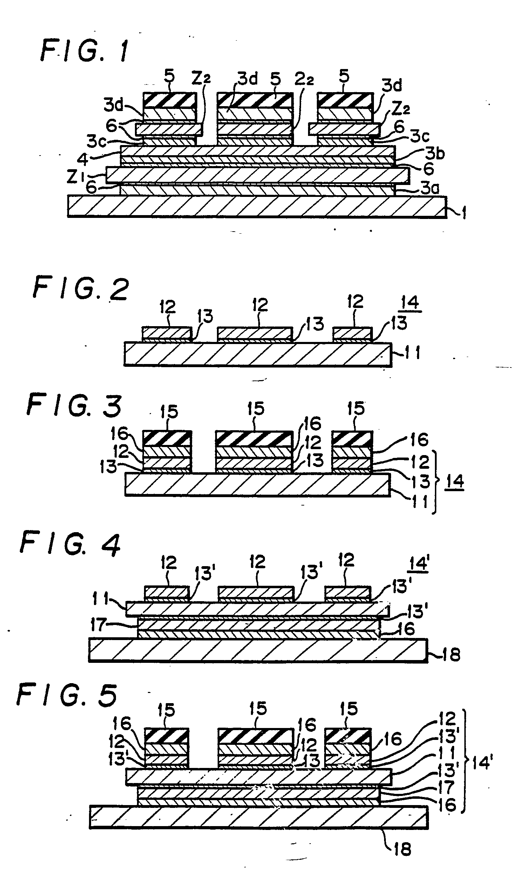

In view of these requirements, a power semiconductor module as shown in Fig. 1 has heretofore been used which employs a heat radiation substrate. In Fig. 1, numeral 1 denotes a heat sink made of copper (Cu) and the like. A first insulating plate $Z_1$ made of $Al_2O_3$ is joined by means of a solder layer 3a onto the heat sink 1 in order to insulate the latter from a thermal diffusion plate described below. The thermal diffusion plate 4 is joined by a solder layer 3b onto the insulating plate $Z_1$. Furthermore, second insulating plates $Z_2$ made of $Al_2O_3$ are joined by means of solder layers 3c onto the thermal diffusion plate 4 in order to insulate the plate 4 from semiconductor elements to be mounted. The semiconductor elements 5 are joined by solder layers 3d onto these insulating plates $Z_2$, respectively. In the Figure, each numeral 6 denotes a joining layer formed between the insulating plate $Z_1$ or $Z_2$ and the solder layers.

However, a thermal radiation substrate used in conventional power semiconductor modules has the drawback that it is extremely complicated in construction, as shown in Fig. 1. This results from the fact that $Al_2O_3$ constituting the first and second insulation plates $Z_1$ and $Z_2$ is low in thermal conductivity (20 W/m.°C) but high in dielectric strength (100 kV/cm), so that both functions, radiation and insulation, are required to be satisfied by employing both materials, Cu and $Al_2O_3$ separately.

On the other hand, aluminium nitride (AlN) has recently attracted attention due to its excellent dielectric strength (140 to 170 kV/cm) and thermal conductivity (90 W/m.°C), and been joined to a copper (Cu) member to form a module substrate. AlN, however, is inferior in wettability with brazing materials, so that it is difficult to obtain a sufficient joining strength even if the joining of an AlN member to a Cu member with the use of silver brazing materials is attempted.

EP-A-0 135 603 (Ant. 54-3 document) describes a Ti-Ag-Cu brazing alloy for brazing Cu to $Al_2O_3$.

It is an object of the present invention to provide a method for bonding of a Cu member to an AlN substrate.

It is a further object of the present invention to provide a Cu wiring sheet in the above method.

The invention comprises a method for bonding of a Cu member to an AlN substrate and is characterized in that an active layer 13 is interposed therebetween, said active layer comprising a laminate of an Ag layer with a thickness of 0,2 to 9μm, an active metal layer (Ti, Zr and/or Hf) with a thickness of 0,1 to 5μm and an (optional) Cu layer with a thickness of 0 to 9μm; upon heat-treatment in a vacuum or inert atmosphere, a Ti-(Zr, Hf)-Ag-Cu alloy layer is formed so that upon cooling the AlN substrate 11 and the Cu member 12 are securely joined together through the alloy layer 13.

Preferably, the active metal layer 13 comprises titanium.

The invention also comprises a method for preparing a highly heat-conductive substrate which is characterized in that an active layer 13 comprising a laminate of an Ag layer with a thickness of 0,2 to 9μm, an active metal layer (Ti, Zr and/or Hf) with a thickness of 0,1 to 5μm and an (optional) Cu layer with a thickness of 0 to 9μm is first provided on the surface of a Cu sheet 12 and the assembly is then bonded to an AlN substrate 11.

Again the active layer 13 preferably comprises titanium.

The invention also comprises a Cu wiring sheet for use in the methods of claims 1 to 4 which comprises an active layer 13 comprising a laminate of an Ag layer with a thickness of 0,2 to 9μm, a layer of an active metal (Ti, Zr and/or Hf) with a thickness of 0,1 to 5μm and an (optional) Cu layer with a thickness of 0 to 9μm.

Preferably, the active metal layer comprises titanium.

Fig. 1 is a cross-sectional view of a power semiconductor module having the conventional radiation substrate.

Fig. 2 is a cross-sectioned view of a power semiconductor module substrate in Example 1 of this invention.

Fig. 3 is a cross-sectional view of a power semiconductor module having semiconductor elements mounted on the module substrate shown in Fig. 2.

Fig. 4 is a cross-sectional view of a power semiconductor module substrate in Example 3 of this invention.

Fig. 5 is a cross-sectional view of a power semiconductor module having semiconductor elements mounted on the module substrate shown in Fig. 4.

Fig. 6 is a cross-sectional view of a power semiconductor module substrate employing the Cu wiring sheet of this invention.

Fig. 7 is a cross-sectional view of a power semiconductor module having semiconductor elements mounted on the module substrate shown in Fig. 6.

The method for preparing the highly heat-conductive substrate according to this invention will be given below, taking an example in which Ti is used as an active metal layer.

Firstly, an active layer comprising an Ag layer and a Ti layer, or an Ag layer, a Ti layer and a Cu layer, and having a thickness of 0.5 to 10 μm is interposed between an AlN substrate and a Cu member.

In this step, methods for interposing the active layer may include a method employing Ag, Ti and Cu metal foils, a method of laminating Ag, Ti and Cu on an AlN member or a Cu member by a sputtering method, a vacuum evaporation method or a plating method, and a method in which stages of the metal foil method, the sputtering method and the vacuum evaporation method are combined.

In any method described above, where the active layer comprisinq an Ag layer and a Ti layer and having a thickness of 0.5 to 10 μm is interposed, it is preferable that the Ag layer is 0.2 to 9 μm thick and the active metal (such as Ti) layer is 0.1 to 5 μm thick. In the case where the active layer comprising an Ag layer, a Ti layer and a Cu layer and having a thickness of 0.5 to 10 μm is interposed, it is preferred that the Ag layer is 0.2 to 9 μm thick, the active metal (such as Ti) layer is 0.1 to 5 μm thick and the Cu layer is not more than 9 μm thick.

When the active layer comprising an Ag layer and a Ti layer, or an Ag layer, a Ti layer and a Cu layer, is less than 0.5 μm in thickness, high bonding strength between the AlN substrate and the Cu member cannot be obtained. On the other hand, when the active layer is more than 10 μm in thickness, molten materials are overflowed to the outer side of the joining part during fusing by heat resulting in the loss of function as a substrate.

Although an Ag layer and a Ti layer, or an Ag layer, a Ti layer and a Cu layer, may be interposed between the AlN substrate and the Cu member in any order, the most stable joining part can be obtained by arranging the Ti layer, the Ag layer and furthermore the Cu layer, if necessary, in this order, on the surface of the AlN substrate.

The number of layers of each Ag, Ti and Cu to be interposed is not necessarily limited to a single one but, if desired, a plurality of the layers can be interposed. Lamination of an Ag layer, a Ti layer or a Cu layer by a sputtering method, a vacuum evaporation method and the like may be effected on either the AlN substrate or the Cu member, but a method of laminating the Ti layer, the Ag layer and optionally the Cu layer on the Cu member in this order may provide a method easy in procedure and also result in stable joining materials.

The joining part between the AlN substrate and the Cu member is then heated in a vacuum or inert atmosphere. In this step, the joining part may be heated under a pressure of 0 to 1 kg/mm² as required; the application of pressure is basically not essential, however. The heating temperature is required to be lower than the melting point of the Cu member. Specifically, heating may be effected within the range of 780 to 1082°C. As a result of this heat treatment, a fused Ag-Cu-Ti alloy liquid is formed between the AlN substrate and the Cu member. When the active layer comprising Ag and Ti is employed, the surface portion of the Cu member in contact with the Ag-Ti layer is fused in part of the above-mentioned temperature by an eutectic reaction with Ag to form a Ti-Ag-Cu alloy layer. Subsequently, the alloy thus obtained is cooled to achieve a highly heat-conductive power semiconductor module substrate in which the AlN substrate and the Cu member are securely joined without any of the Ag-Ti-Cu alloy fused liquid having overflowed towards the joining part or the outer side thereof.

In another embodiment according to this invention, the active layer comprising an Ag layer and a Ti layer, or an Ag layer, a Ti layer and a Cu layer, is previously provided on the surface of a Cu sheet, which is a wiring layer, to obtain a Cu wiring sheet. This is then provided on the AlN substrate so that the active layer side thereof is in contact with the AlN substrate, and heated to convert said layer to an alloy, thereby joining it to the AlN substrate.

In this embodiment, methods for providing the active layer on the surface of a Cu sheet may include, for example, a method in which an active metal layer and a soft metal layer are laminated directly by a vacuum evaporation, a sputtering method or a plating method, a method in which an active metal foil and a soft metal foil are joined on the Cu sheet by the use of bonding agents, a method in which powders of an active metal or soft metal are mixed with an organic solvent to form a paste, the resulting paste then being applied on a Cu sheet, and a method in which the above methods are combined.

In this embodiment, the order for interposing the active layer between the AlN substrate and the Cu sheet is the same as in the first embodiment described above.

As methods for processing the Cu wiring sheet according to this invention into the desired shape, press processing, photo-etching processing may be used, for example. The Cu sheet of this invention is excellent in processability as it possesses excellent ductility and has a structure basically comprising a Cu sheet, which can be readily etched, and on which an active layer with a thickness of 10 μm or less is easily provided.

Next, a method for joining the present Cu wiring sheet to an AlN substrate will be described below.

The Cu wiring sheet of this invention is laminated on a AlN substrate so that the active layer side of the sheet may be in contact with the AlN substrate, and the joining parts of both members are then heated by means of high frequency induction, for example, in a vacuum or an inert atmosphere. In this case, a small pressure (0 to 1 kg/mm²) may be applied to bring the joining surfaces in close contact with each other during heating, although it is not essential to apply pressure.

The heating temperature is required to be less than the melting point of the Cu sheet, and preferably ranges from 780 to 1082°C. By this heat treatment, a fused liquid alloy, for example, of Ag-Cu-Ti is formed between the AlN substrate and

the Cu sheet, and the resulting liquid is solidified by the subsequent cooling without any liquid overflowing towards the outer side of the joining part. The AlN substrate and the Cu sheet are thereby securely joined to form an AlN substrate suitable for a high power semiconductor substrate.

Examples of this invention in which the present power semiconductor module substrate is employed will be illustrated below with reference to the accompanying drawings.

Example 1

Firstly, as shown in Fig. 2, a plurality of sheet of the Cu member 12, deposited with a Ti layer of 0.5 μm thickness and an Ag layer of 1.0 μm thickness in this order, as an active layer by means of a vacuum evaporation method, and an AlN substrate 11, functioning simultaneously as an insulating plate, a radiation plate and a heat sink are washed and degreased with trichlene and acetone, and then set in a hot press, maintained in a vacuum of 2 x 10⁻⁵ Torr, in such a manner that the vacuum evaporated side of the Cu member is in close contact with the AlN substrate.

Subsequently, a pressure of 0.1 kg/mm² is applied from above and below on a joining part between the AlN substrate and the plurality sheets of the Cu member, the joining part being maintained at 830°C for 10 minutes by means of high frequency heating to form a fused Ag-Ti-Cu liquid alloy. After heating, the resulting liquid is cooled in an argon gas atmosphere to obtain a power semiconductor module substrate 14 having structure in which the Cu member 12 is joined to the AlN substrate by an Ag-Ti-Cu alloy layer 13 obtained from the active layer comprising an Ag layer and a Ti layer.

The semiconductor module substrate obtained in this manner is one in which the AlN substrate 11 and the Cu member 12 are securely joined with each other by the allo layer 13, no overflowing of the alloy layer from the joining part being observed.

As shown in Fig. 3, by mounting a semiconductor element 15 on the Cu member 12 of the above module substrate 14 with Pb-Sn type solder 16, a power semiconductor module with a thermal conductivity of 88 W/K.cm in the direction from the semiconductor element 15 to the AlN substrate 11 (thickness direction) is obtained, which is capable of radiating effectively a large quantity of heat generated in the semiconductor 15 from the Cu member 12 and the AlN substrate 11.

Example 2

Shown in cross-section in Fig. 4 are a plurality of sheets of Cu members 12 and a thermal diffusion plate 17, each having an Ag layer with a thickness of 2 μm and a Ti layer of 1 μm thickness deposited in this order, respectively, on the joining surfaces defined between an AlN substrate 11, by a vacuum evaporation method. These and an AlN substrate 11 are then washed and degreased with trichlene and acetone, and set in a hot press

maintained in a vacuum of 2 x 10⁻⁵ Torr, so that the vacuum evaporated sides of the Cu member 12 and the thermal diffusion plate 17 are in close contact with upper and lower surfaces of the AlN, respectively.

Subsequently, pressure of 0.1 kg/mm² is applied from above and below on the joining parts between the upper Cu member 12 and the lower thermal diffusion plate 17, and the joining parts between the AlN substrate 11 and the Cu member 12 and between the AlN substrate 11 and the thermal diffusion plate 17 are maintained at 830°C for 10 minutes by means of high frequency heating to form a fused Ag-Ti-Cu liquid alloy. The resulting liquid is then cooled in an argon gas atmosphere to join the Cu member 12 on the upper surface of AlN substrate 11, and the thermal diffusion plate 17 on the lower side of the AlN substrate 11 respectively by means of the Ag-Ti-Cu alloy 13.

The semiconductor module substrate 14 obtained in this way is one in which the AlN substrate 11 and the Cu member 12, and the AlN substrate 11 and the thermal diffusion plate 17 are joined securely with each other by the alloy layer 13', respectively, no overflowing of the alloy layers 13' from the joining part being observed.

As shown in Fig. 5, by mounting a semiconductor element 15 on the Cu member 12 of the above module substrate 14' through Pb-Sn type solder 16, a power semiconductor module with a thermal conductivity of 88 W/K.cm in the direction from the semiconductor element 15 to the AlN substrate 11 (thickness direction) is obtained, which is capable of radiating effectively a large quantity of heat generated in the semiconductor 15 from the Cu member 12' the AlN substrate 11, thermal diffusion plate 17 and the heat sink 18.

Example 3

Firstly, an AlN substrate having a Ti layer of 0.5 μm thickness deposited thereon by a vacuum evaporation method, and a plurality of sheets of the Cu member 12 having an Ag layer of 3 μm thickness plated thereon and a Ti layer with a thickness of 0.5 μm deposited thereon by a vacuum evaporation method, are washed and degreased with trichlene and acetone, and then set in a hot press maintained in a vacuum of 2 x 10⁻⁵ Torr, so that the vacuum evaporated sides or plated side of the AlN substrate and the Cu member are in close contact with each other.

Subsequently, pressure of 0.1 kg/mm² is applied from above and below on a joining part between the AlN base plate and the plural sheets of Cu member, the joining part being maintained at 830°C for 10 minutes by means of high frequency heating to form a fused Ag-Ti-Cu liquid alloy. After heating, the resulting liquid is cooled in an argon gas atmosphere to obtain a power semiconductor module substrate having a structure in which the Cu member is joined to the AlN substrate by an Ag-Ti-Cu alloy layer.

The semiconductor module substrate obtained is one in which the AlN substrate and the Cu member are securely joined with each other by the alloy layer, no overflowing of the alloy layer from the joining part being observed.

By mounting a semiconductor element on the Cu member of the above module substrate with a Pb-Sn type solder, a power semiconductor module is obtained with a thermal conductivity of 88 W/K.cm in the direction of thickness, which is capable of effectively radiating a large quantity of heat generated in the semiconductor from the Cu member and the AlN substrate.

### Example 4

Firstly, a plurality of sheets of the Cu member 12, deposited with an Ag layer of 1 μm thickness and a Ti layer of 0.6 μm thickness in this order by a vacuum evaporation method, and an AlN substrate are washed and degreased with trichlene and acetone, and then set in a hot press maintained in a vacuum of $2 \times 10^{-5}$ Torr, so that the vacuum evaporated side of the Cu member is in close contact with the AlN.

Subsequently, a pressure of 0.1 kg/mm$^2$ is applied from above and below on a joining part between the AlN substrate and the plural sheets of Cu member, the joining part being maintained at 830°C for 10 minutes by means of high frequency heating to form a fused Ag-Ti-Cu liquid alloy. After heating, the resulting liquid is then cooled in an argon gas atmosphere to obtain a power semiconductor module substrate.

The semiconductor module substrate obtained in this manner is one in which the AlN substrate and the Cu member 12 are securely joined with each other by the alloy layer 13, no overflowing of the alloy layer from the joining part being observed. By observing the joining part with a microscope set to a factor of manification of 100, the substrate obtained in the above manner is confirmed to have a good joining state without any crack generation in the AlN substrate.

Moreover, by mounting a semiconductor element on the Cu member of the above module substrate with a Pb-Sn type solder, a highly reliable power semiconductor module having a heat conductivity of 88 W/K.cm in the direction of thickness is obtained in a manner similar to that in Example 1, which is capable of radiating effectively a large quantity of heat.

### Example 5

Firstly, a plurality of sheets of the Cu member 12, deposited with a Ti layer of 0.5 μm thickness, an Ag layer of 2 μm thickness and a Cu layer of 2 μm thickness in this order by a vacuum evaporation method, and an AlN substrate are washed and degreased with trichlene and acetone.

Subsequently, a pressure of 0.1 kg/mm$^2$ is applied from above and below on a joining part between the AlN substrate and the plurality of sheets of the Cu member, which was set so that the vacuum evaporated side of the Cu member is in close contact with the AlN, the joining part being maintained at 830°C for 10 minutes in a highly pure argon gas (Ar) atmosphere to form an Ag-Ti-Cu alloy layer. The resulting layer is cooled in an argon atmosphere to obtain a power semiconductor module subtrate having a structure in which the Cu member is joined to the AlN substrate by the Ag-Ti-Cu alloy layer.

The semiconductor module substrate obtained in this way is one in which the AlN substrate and the Cu member are joined securely with each other by the alloy layer, no overflowing of the alloy layer from the joining part being observed. By mounting a semiconductor element on the Cu member of the above module substrate with a Pb-Sn type solder, a power semiconductor module having thermal conductivity of 88 W/K.cm in the direction of thickness is obtained, which is capable of radiating effectively a large quantity of heat generated in the semiconductor from the Cu member and the AlN substrate.

### Example 6

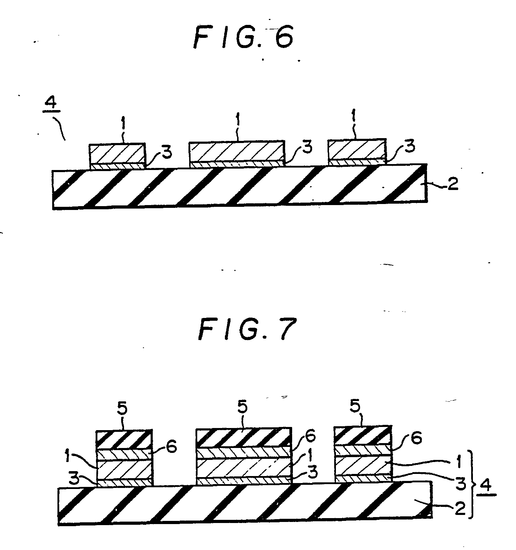

A Cu wiring sheet, deposited with a Ti layer of 1 μm thickness and an Ag layer of 4 μm thickness in this order by a vacuum evaporation method, thus giving a total thickness of 5 μm as an active layer, is processed to form a predetermined shape by a photo-etching method. As shown in Fig. 6, a plurality of sheets of the Cu wiring sheet 1, an AlN substrate 2, functioning simultaneously as an insulating plate, a radiation plate and a heat sink are washed and degreased with trichlene and acetone, and then set in a hot press maintained in a vacuum of $2 \times 10^{-5}$ Torr, so that the vacuum evaporated side of the Cu member overlapping the AlN substrate 2 is in contact with the AlN.

Subsequently, while a pressure of 0.1 kg/mm$^2$ is applied from above and below on a joining part between the AlN substrate 2 and the Cu wiring sheet, the joining part is maintained at 830°C for 10 minutes by means of high frequency heating to form a fused Ag-Ti-Cu liquid alloy. After heating, the resulting liquid is cooled in an argon gas atmosphere to obtain a power semiconductor module substrate 4 having a structure in which the Cu wiring sheet is joined to the AlN substrate 2 by an Ag-Ti-Cu alloy layer 3 obtained by fusing and solidifying the Ti active layer, as shown in Fig. 6.

The semiconductor module substrate 4 obtained by this method is one in which the AlN substrate 2 and the Cu member 1 are securely joined with each other by the alloy layer 3, no overflowing of the alloy layer 3 from the joining part being observed.

As shown in Fig. 7, semiconductor elements 5 are mounted on the above module substrate 4 with a Pb-Sn type solder 6. The measurement of a heat conductivity in a direction from the semiconductor element 5 to the AlN substrate 2 (thickness direction) gives a value of 88 W/K.cm, and the substrate is confirmed to have the capability of radiating effectively a large quantity of heat generated in the semiconductor 5 through the Cu wiring sheet and the alloy layer 3 towards the AlN substrate 2 and to have a good joining state between the Cu wiring sheet and AlN substrate 2.

Example 7

A Cu wiring sheet 1 deposited with a Ti layer of 2 µm thickness by a vacuum evaporation and to which adhered an Ag foil with a thickness of 5 µm by use of an organic bonding agent is formed into the predetermined shape by a blanking processing.

Following this, the Cu wiring sheet 1 obtained and the AlN substrate 2 are washed and degreased with trichlene and acetone, and then set in a hot press maintained in a vacuum of 2 x $10^{-5}$ Torr, so that the active layer deposited side of the Cu member is in contact with the AlN.

Subsequently, a pressure of 0.05 kg/mm² is applied from above and below on a joining part between the AlN substrate 2 and the Cu wiring sheet 1, the joining part being maintained at 830°C for 10 minutes by means of high frequency heating to form fused Ag-Ti-Cu alloy liquid. After heating, the resulting liquid is cooled in an argon gas atmosphere to form a power semiconductor module substrate 4 having a structure in which the Cu wiring sheet 1 is joined to the AlN substrate 2 by an alloy layer obtained by fusing and solidifying of the Ag-Ti-Cu active layer as shown in Fig. 6.

The semiconductor module substrate 4 obtained here is one in which the AlN substrate 2 and the Cu wiring sheet 1 are securely joined with each other by the alloy layer 3, with a good joining state and without any overflowing of the alloy layer 3 from the joining part.

Claims

1. A method for bonding of a Cu member to an AlN substrate, characterized in that an active layer (13) is interposed therebetween, said active layer comprising a laminate of an Ag layer with a thickness of 0,2 to 9µm, an active metal layer (Ti, Zr and/or Hf) with a thickness of 0,1 to 5µm and an (optional) Cu layer with a thickness of 0 to 9µm; upon heat-treatment in a vacuum or inert atmosphere, a Ti (Zr, Hf)-Ag-Cu alloy layer is formed so that upon cooling the AlN substrate (11) and the Cu member (12) are securely joined together through the alloy layer (13).

2. The method of claim 1, wherein said active metal layer (13) comprises titanium.

3. A method for preparing a highly heat-conductive substrate, characterized in that an active layer (13) comprising a laminate of an Ag layer with a thickness of 0,2 to 9µm, an active metal layer (Ti, Zr and/or Hf) with a thickness of 0,1 to 5µm and an (optional) Cu layer with a thickness of 0 to 9µm is first provided on the surface of a Cu sheet (12) and the assembly is then bonded to an AlN substrate (11), the active layer (13) thereof being in contact with the AlN substrate and being converted to an alloy.

4. The method of claim 3, wherein said active metal layer (13) comprises titanium.

5. A Cu wiring sheet for use in the methods of claims 1 to 4 which comprises an active layer (13) comprising a laminate of an Ag layer with a thickness of 0,2 to 9µm, a layer of an active metal (Ti, Zr and/or Hf) with a thickness of 0,1 to 5µm and an (optional) Cu layer with a thickness of 0 to 9µm.

6. The sheet according to claim 5 wherein said active metal layer comprises titanium.

Patentansprüche

1. Verfahren zum Binden eines Kupferteils an ein AlN-Substrat, dadurch gekennzeichnet, dass eine aktive Schicht (13) dazwischengelegt wird, wobei die aktive Schicht ein Laminat aus einer Ag-Schicht mit einer Dicke von 0,2 bis 9µm und einer aktiven Metallschicht (Ti, Zr und/oder Hf) mit einer Dicke von 0,1 bis 5µm und (gewünschtenfalls) eine Cu-Schicht mit einer Dicke von 0 bis 9µm umfasst; bei einer Wärmebehandlung in einem Vakuum oder einer inerten Atmosphäre eine Ti(Zr, Hf)-Ag-Cu-Legierungsschicht gebildet wird, so dass beim Abkühlen das AlN-Substrat (11) und das Kupferteil (12) fest miteinander durch die Legierungsschicht (13) verbunden sind.

2. Verfahren gemäss Anspruch 1, bei welchem die aktive Metallschicht (13) Titan einschliesst.

3. Verfahren zur Herstellung eines hoch wärmeleitfähigen Substrates, dadurch gekennzeichnet, dass eine aktive Schicht (13), umfassend ein Laminat aus einer Ag-Schicht mit einer Dicke von 0,2 bis 9µm, eine aktive Metallschicht (Ti, Zr und/oder Hf) mit einer Dicke von 0,1 bis 5µm und (gewünschtenfalls) einer Cu-Schicht mit einer Dicke von 0 bis 9µm zunächst auf der Oberfläche eines Kupferbleches (12) ausgebildet wird und die Anordnung dann an ein AlN-Substrat (11) gebunden wird, wobei die aktive Schicht (13) darin in Kontakt mit dem AlN-Substrat ist und in eine Legierung überführt wird.

4. Verfahren gemäss Anspruch 3, bei welchem die aktive Metallschicht (13) Titan einschliesst.

5. Ein Cu-Verdrahtungsblech für die Verwendung in dem Verfahren gemäss Ansprüchen 1 bis 4, welches eine aktive Schicht (13) umfasst, umfassend ein Laminat aus einer Ag-Schicht mit einer Dicke von 0,2 bis 9µm, einer Schicht aus einem aktiven Metall (Ti, Zr und/oder Hf) mit einer Dicke von 0,1 bis 5µm und (gewünschtenfalls) einer Cu-Schicht mit einer Dicke von 0 bis 9µm.

6. Blech gemäss Anspruch 5, bei dem die aktive Metallschicht Titan einschliesst.

Revendications

1. Procédé pour lier un élément en Cu à un substrat en AlN, caractérisé en ce qu'une couche active (13) est interposée entre eux, la couche active comportant un stratifié d'une couche de Ag avec une épaisseur de 0,2 à 9 µm, d'une couche métallique active (Ti, Zr et/ou Hf) avec une épaisseur de 0,1 à 5 µm et d'une couche de Cu (en option) ayant une épaisseur de 0 à 9 µm; lors du traitement thermique sous vide ou en atmosphère inerte, une couche d'alliage Ti (Zr, Hf) Ag Cu est formée de sorte que par refroidissement le substrat (11) en AlN et l'élément (12) en Cu sont fixés solidement par l'intermédiaire de la couche d'alliage (13).

2. Procédé selon la revendication 1, dans lequel la couche métallique active (13) comporte du titane.

3. Procédé pour préparer un substrat hautement conducteur de la chaleur, caractérisé en ce qu'une couche active (13) comprenant un stratifié d'une couche de Ag avec une épaisseur de 0,2 à 9 μm, d'une couche métallique active -(Ti, Zr et/ou Hf) ayant une épaisseur de 0,1 à 5 μm et d'une couche de Cu (en option) ayant une épaisseur de 0 à 9 μm est tout d'abord prévue sur la surface d'une feuille (12) en Cu et l'ensemble est alors lié à un substrat (11) en AlN, la couche active (13) étant en contact avec le substrat en AlN et étant transformée en alliage.

4. Procédé selon la revendication 3, dans lequel la couche métallique active (13) comporte du titane.

5. Feuille de câblage en Cu pour emploi dans les procédés des revendications 1 à 4, qui comprend une couche active (13) comportant un stratifié d'une couche de Ag ayant une épaisseur de 0,2 à 9 μm, d'une couche métallique active (Ti, Zr et/ou Hf) ayant une épaisseur de 0,1 à 5 μm et d'une couche de Cu (en option) ayant une épaisseur de 0 à 9 μm.

6. Feuille selon la revendication 5, dans laquelle la couche métallique active comporte du titane.

FIG. 1

FIG. 2

FIG. 3

FIG. 4

FIG. 5

1

# FIG. 6

# FIG. 7